# EUROPEAN PATENT SPECIFICATION

(11) **EP 2 894 675 B1**
(45) Date of publication and mention of the grant of the patent: **05.10.2016**
(21) Application number: 14150535.4
(22) Date of filing: 09.01.2014
(51) Int. Cl.: H01L 31/048

(54) **THERMALLY CONDUCTIVE ENCAPSULATE AND SOLAR CELL MODULE COMPRISING THE SAME**
WÄRMELEITENDE EINKAPSELUNG UND SOLARZELLENMODUL DAMIT
ENCAPSULATION THERMOCONDUCTRICE ET MODULE DE CELLULE SOLAIRE LA COMPRENANT

(43) Date of publication of application: 15.07.2015
(73) Proprietor: Taiflex Scientific Co., Ltd., Kaohsiung (TW)
(72) Inventor: Wang, Fu-Min, KAOHSIUNG (TW); Teng, I-Ling, KAOHSIUNG (TW); Hung, Tsung-Tai, KAOHSIUNG (TW); Lee, Yu-Hsien, KAOHSIUNG (TW); Hung, Tzu-Ching, KAOHSIUNG (TW); Huang, Chen-Hsin, KAOHSIUNG (TW)
(74) Representative: Casalonga, Axel

(56) References cited:
- WO-A1-2012/140585
- WO-A2-2008/014492
- US-A1- 2010 043 871
- LEE B ET AL: "Thermally conductive and electrically insulating EVA composite encapsulants for solar photovoltaic (PV) cell", INTERNET CITATION, [Online] vol. 2, no. 5, 1 January 2008 (2008-01-01) , pages 357-363, XP003030830, Retrieved from the Internet: URL:http://www.expresspolymlett.com/articl es/EPL-0000613_article.pdf> [retrieved on 2013-05-01]
- MINGXIA SHEN ET AL: "Preparation of an Al2O3-EVA Co-film and its Thermal Conductivity", JOURNAL OF ELASTOMERS AND PLASTICS, SAGE PUBLICATIONS LTD, GB, vol. 42, no. 6, 1 November 2010 (2010-11-01), pages 499-516, XP008169484, ISSN: 0095-2443, DOI: 10.1177/0095244310376922 [retrieved on 2010-07-20]

## Description

### 1. Field of the Invention

The present invention is related to a semiconductor device technology, particularly to a thermally conductive encapsulate and a solar cell module comprising the same.

### 2. Description of the Prior Art(s)

A commonly known solar cell module is composed of a transparent substrate, a first sealing resin layer, photoelectric conversion elements, a second sealing resin layer and a back-sheet from the top to bottom. The photoelectric conversion elements are enclosed by the first and the second sealing resin layers to be isolated from the moisture in the exterior environment

US 2010/043871 A1 discloses a solar panel (10) comprising a transparent substrate (12), a sealing resin layer (14) disposed on the transparent substrate (12), a photoelectric conversion element (16) disposed on the sealing resin layer (14), a thermally conductive composite layer (18) disposed on the photoelectric conversion element and the sealing resin layer.

However, the conventional solar cell modules convert merely 14% to 22% of light energy into electricity, and the rest of the energy is reflected to the environment or converted into heat and increases the operating temperature of the solar cell module, thereby decreasing the conversion efficiency of the solar cell module.

To overcome the foregoing problems, an improved solar cell module comprising a heat sink mounted on the back-sheet is provided. With the multiple extension parts of the heat sink, the heat-dissipation area of the solar cell module is increased, thereby reducing the solar cell module's operating temperature. However, the improved solar cell module has several problems:
(1) Modification of original encapsulation process is required, such that the improved solar cell module is not convenient for mass production.
(2) The applicability of the solar cell module is restricted by the increased volume and thickness.
(3) Heat generated from the photoelectric conversion element cannot be transferred to the heat sinks through the second sealing resin layer and the back-sheet since the photoelectric conversion element is enclosed by two sealing resin layer with relatively low thermal conductivity. Therefore, mounting the heat sinks at the exteriors of the solar cell module is useless for reducing the solar cell module's operating temperature.

To overcome the foregoing shortcomings, an objective of the present invention is to provide an effective pathway for dissipating the heat of the photoelectric conversion element to the environment, thereby decreasing the solar cell module's operating temperature and enhancing its conversion efficiency and power output as well.

Another objective of the present invention is to mitigate the aging of the interior elements in the solar cell module at the higher operating temperature for long time period instead of increasing the solar cell module's size or modifying the encapsulation process of the solar cell module.

To achieve the foregoing objective, the present invention provides a thermally conductive encapsulate comprising a thermally conductive composite layer and an adhesive resin layer. The thermally conductive composite layer includes a thermoplastic resin and inorganic powders dispersed in the thermoplastic resin in an amount of 40 vol% to 70 vol% based on the volume of the thermally conductive composite layer, and the thermally conductive composite layer has a thermal conductivity ranging from 0.5 W/m*K to 8 W/m*K. Said adhesive resin layer is disposed on the thermally conductive composite layer and has a thermal conductivity ranging from 0.05 W/m*K to 0.4 W/m*K. A percentage of a thickness of the adhesive resin layer relative to a total thickness of the thermally conductive encapsulate ranges from 0.1% to 10%, and the thermally conductive encapsulate comprising the thermally conductive composite layer and the adhesive resin layer has an overall thermal impedance ranging from 0.01 °C*in²/W to 0.72 °C*in²/W.

In accordance with the present invention, the overall thermal impedance of the thermally conductive encapsulate is reduced to less than 0.72 °C-in²/W by controlling (1) the amount of the inorganic powders and (2) the ratio of the adhesive resin layer relative to the thermally conductive composite layer and the adhesive resin layer in thickness at the same time. Hence, applying the thermally conductive encapsulate to a solar cell module is useful for dissipating the heat generated from the photoelectric conversion element, whereby the aging effect of the solar cell module and undesired increase of operating temperature are mitigated, such that the solar cell comprising the thermally conductive encapsulate provides a path of heat dispersed to the heat sink, which improves conversion efficiency and increases power output.

Said total thickness of the thermally conductive encapsulate is directed to the sum of the thermally conductive composite layer's thickness and the adhesive resin layer's thickness.

Preferably, a hot melting process or a wet coating process may be used to form the adhesive resin layer on the thermally conductive composite layer.

Preferably, the amount of the inorganic powders ranges from 20 vol% to 70 vol% based on the volume of the thermally conductive composite layer.

Preferably, the thermoplastic resin of the thermally conductive composite layer has a thermal conductivity from 0.05 W/m*K to 0.4 W/m*K.

Preferably, the total thickness of the thermally conductive encapsulate ranges from 20 micrometers to 600 micrometers.

Preferably, in the thermally conductive encapsulate, the thermally conductive encapsulate has an overall thermal impedance ranging from 0.01 °C-in²/W to 0.72° C-in²/W. In a more feasible embodiment, the thermally conductive encapsulate has an overall thermal impedance ranging from 0.1 °C-in²/W to 0.72 °C-in²/W.

Preferably, said thermally conductive encapsulate has a volume resistivity higher than 1.0×10¹⁴ Ω*cm, 22 kV/mm of insulation breakdown voltage, an insulation moisture absorption at insulation breakdown voltage (20°C/24 hours) less than 0.1%, a longitudinal shrinkage less than 3% and a transverse shrinkage less than 1.0 % (120°C/3 minutes, measured by ASTM D1204).

The present invention also provides a solar cell module, which comprises a transparent substrate, a sealing resin layer, a photoelectric conversion element, a thermally conductive encapsulate as mentioned above and a back-sheet. The sealing resin layer is disposed on the transparent substrate, and the photoelectric conversion element is disposed on the sealing resin layer. The thermally conductive encapsulate is disposed on the photoelectric conversion element and the sealing resin layer, the adhesive resin layer of the thermally conductive encapsulate contacts the photoelectric conversion element, and the back-sheet is disposed on the thermally conductive composite layer of the thermally conductive encapsulate.

Preferably, the solar cell module comprises another thermally conductive composite layer disposed at exteriors of the thermally conductive encapsulate and the back-sheet and in contact with the photoelectric conversion element. Accordingly, heat generated by the photoelectric conversion element is conducted out of the solar cell module by said another thermally conductive composite layer directly or in combination with the thermally conductive composite layer of the thermally conductive encapsulate, such that the operating temperature of the solar cell module can be decreased.

Preferably, the solar cell module comprises a thermally conductive sealant and a metal frame, the metal frame is bonded to exteriors of the transparent substrate, the sealing resin layer, the thermally conductive encapsulate and the back-sheet by the thermally conductive sealant. With this configuration, heat generated by the photoelectric conversion element can be conducted through a dissipation pathway from the thermally conductive composite layer, the thermally conductive sealant and the metal frame and finally out of the solar cell module to decrease the solar cell module's operating temperature.

More preferably, the solar cell module comprises another thermally conductive composite layer disposed between the thermally conductive sealant and the thermally conductive encapsulate and between the thermally conductive sealant and the back-sheet, and said another thermally conductive composite layer is in contact with the photoelectric conversion element. Therefore, heat generated by the photoelectric conversion element also can be conducted to the environment by said another thermally conductive composite layer directly or through a dissipation pathway from the thermally conductive composite layer, the thermally conductive sealant and the metal frame, so as to decrease the solar cell module's operating temperature.

Preferably, said another thermally conductive composite layer comprises a thermoplastic resin and inorganic powders dispersed in the thermoplastic resin of said another thermally conductive composite layer in an amount of 10 vol% to 70 vol% based on the volume of said another thermally conductive composite layer, whereby said another thermally conductive composite layer has a thermal conductivity ranging from 0.5 W/m*K to 8 W/m*K. More preferably, the amount of the inorganic powders of said another thermally conductive composite ranges from 20 vol% to 70 vol% based on the volume of said another thermally conductive composite layer.

Preferably, the thermally conductive sealant has a thermal conductivity ranging from 0.05 W/m*K to 0.4 W/m*K.

In accordance with the present invention, the adhesive resin layer includes a thermoplastic resin. Said thermoplastic resin included in the adhesive resin layer, in the thermally conductive composite layer or in said another thermally conductive composite layer may be polyolefins, such as, but not limited to, poly(ethylene-co-propylene), poly(propylene-co-ethylene), polyethylene ionomer, ethylene-ethylene vinyl acetate copolymer or cross-linked polyethylene. More specifically, the thermoplastic resin may be, but not limited to, ethylene-acrylate copolymer resin, ethylene-glycerin copolymer resin, ethylene-vinyl acetate copolymer resin (EVA), polyvinyl butyral (PVB), thermoplastic polyurethane (TPU) or polyethylene-glycidyl methacrylate (EGMA).

Said adhesive resin layer or the sealing resin layer may include an adhesive material such as silicone resin or hot melt adhesive.

Said sealing resin layer has a light transmittance more than 92% and includes a material such as ethylene-acrylate copolymer resin, ethylene-glycerin copolymer resin, ethylene-vinyl acetate copolymer resin, polyvinyl butyral, thermoplastic polyurethane or polyethylene-glycidyl methacrylate.

Said transparent substrate has a light transmittance more than 92%, and may be a glass substrate.

Said photoelectric conversion element may be a monocrystalline silicon cell or a polycrystalline silicon chip.

Said back-sheet is a plastic sheet with good weather resistance and good insulating property, which may be made of polyvinyl fluoride (PVF) or polyethylene terephthalate (PET).

Preferably, the inorganic powders have a median particle size equal to or less than 20 micrometers; more preferably, ranging from 1 micrometer to 20 micrometers.

Even more preferably, the inorganic powders have a median particle size ranging from 1 micrometer to 3 micrometers to be well-dispersed in the thermoplastic resin. Accordingly, a thermally conductive composite layer or another thermally conductive composite layer comprising the inorganic powders obtains a higher thermal conductivity.

Preferably, the inorganic powders may be made of a material such as inorganic oxide, inorganic nitride or any combination thereof. More specifically, the material of the inorganic powders includes aluminum oxide (Al₂O₃), aluminum nitride (AlN), boron nitride (BN), silicon carbide or any combination thereof. More preferably, the material of the inorganic powders is boron nitride or aluminum nitride.

In the encapsulation process of the solar cell module, the substrate, the sealing resin layer, the photoelectric conversion element, the thermally conductive encapsulate and the back-sheet are stacked into a laminated structure, then a metal frame loaded with silicone resin sealant or a hot melt adhesive is used to encapsulate the laminated structure. After installation of a junction box and conductive wires, an encapsulated solar cell module is obtained. Optionally, the substrate, the sealing resin layer, the photoelectric conversion element, the thermally conductive encapsulate and the back-sheet also can be enclosed and sealed by a sealing tape, such as acrylic foaming tape, polyethylene foaming tape or butyl rubber foaming tape, to form a laminated structure, and the laminated structure is then pressed into the metal frame to obtain an encapsulated solar cell module.

In conclusion, the thermally conductive encapsulate is capable of having an overall thermal impedance less than 0.72 °C-in²/W when (1) the amount of the inorganic powders ranges from 10 vol% to 70 vol% based on the volume of the thermally conductive composite layer and (2) the percentage of the adhesive resin layer relative to the thermally conductive composite layer and the adhesive resin layer ranges from 0.1 % to 10% in thickness. The thermally conductive encapsulate of the present invention not only provides sealing, insulating and adhesive properties same as the conventional sealing layer, but also dissipates the heat generated from the photoelectric conversion element to the environment effectively without increasing the thickness or volume of the solar cell module and without modifying the original encapsulation process. Accordingly, the decreased operating temperature of the solar cell module is beneficial to mitigate the aging of the interior elements in the solar cell module at the higher operating temperature and to improve the solar cell module's conversion efficiency and power output.

Other objectives, advantages and novel features of the invention will become more apparent from the following detailed description when taken in conjunction with the accompanying drawings and tables.

### IN THE DRAWINGS

Fig. 1 is a schematic view of Examples 1 to 3 of thermally conductive encapsulates in accordance with the present invention;
Fig. 2 illustrates the thermal conductivities of a conventional sealing layer and the thermally conductive encapsulates of Examples 1 and 3;
Fig. 3 is a schematic view of Examples 4 to 6 of solar cell modules in accordance with the present invention;
Fig. 4 is a schematic view of Example 7 of a solar cell module in accordance with the present invention;
Fig. 5 illustrates the operating temperatures of the solar cell modules of Examples 5 and Comparative example 2 at various solar irradiations; and
Fig. 6 illustrates the power output generated by the solar cell modules of Examples 5 and Comparative example 2 at various solar irradiations.

Hereinafter, one skilled in the arts can easily realize the advantages and effects of a thermally conductive encapsulate and a solar cell module comprising the same in accordance with the present invention from the following examples and tables. The descriptions proposed herein are just preferable examples for the purpose of illustrations only, not intended to limit the scope of the invention. Various modifications and variations could be made in order to practice or apply the present invention without departing from the spirit and scope of the invention.

### Preparation examples 1 to 4

Raw material:
1. Ethylene methacrylic acid resin with a melting index (MI) of 8 at 190°C and having a thermal conductivity of 0.32 W/m*K, as a thermoplastic resin; and
2. Aluminum oxide powders having a median particle size about 5 micrometers, as inorganic powders.

The ethylene methacrylic acid resin and aluminum oxide powders were mixed by a twin screw extruder with various ratios listed in Table 1 to obtain the thermally conductive composite masterbatches of Preparation examples 1 to 4. The thermal conductivities of thermally conductive composite masterbatches were measured with a thermal conductivity meter according to the ASTM E1461, the results were listed in Table 1.

**Table 1: the amounts of aluminum oxide (Al₂O₃) and ethylene methacrylic acid resin (EMA resin) based on the volume of the thermally conductive resin masterbatch (unit: volume percent (vol%)) and the thermal conductivity of the thermally conductive resin masterbatch in Preparation examples 1 to 4**

| Preparation examples No. | amount of Al₂O₃ | amount of EMA resin | thermal conductivity of the thermally conductive resin masterbatch |
|---|---|---|---|
| 1 | 0 vol% | 100 vol% | 0.32 W/m*K |
| 2 | 40 vol% | 60 vol% | 0.59 W/m*K |
| 3 | 60 vol% | 40 vol% | 0.87 W/m*K |
| 4 | 80 vol% | 20 vol% | 1.51 W/m*K |

As shown in Table 1, the thermal conductivities of the thermally conductive resin masterbatches were increased from 0.32 W/m*K (Preparation example 1) to 1.51 W/m*K (Preparation example 4) as the amounts of the aluminum oxides content increased.

### Comparative example 1: conventional sealing layer

In the comparative example, the conventional sealing layer was made of pure EMA resin without any inorganic powders. The pure EMA resin was directly formed into a 15 cm* 15 cm and 220 µm-thick conventional sealing layer by blown film extrusion. The thermal impedance of the conventional sealing layer was listed in below Table 2.

### Examples 1 to 3: thermally conductive encapsulates

The thermally conductive resin masterbatches obtained from Preparation examples 2 to 4 were used to prepare the thermally conductive encapsulates of Examples 1 to 3. Said thermally conductive encapsulates were prepared by a similar method as follows.

A thermally conductive resin masterbatch was formed into a 15 cm* 15 cm and 200 µm-thick thermally conductive composite layer by blown film extrusion. Then a 20 µm-thick EGMA resin layer, as an adhesive resin layer, was formed on the thermally conductive composite layer by hot melting, so as to obtain a thermally conductive encapsulate.

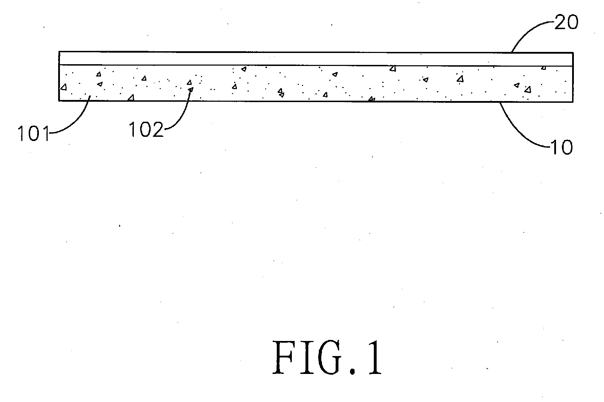

With reference to Fig. 1, the thermally conductive encapsulate prepared from the aforementioned method comprises a thermally conductive composite layer (10) and an adhesive resin layer (20).

The thermally conductive composite layer (10) comprises a thermoplastic resin (101) and multiple inorganic powders (102) dispersed in the thermoplastic resin (101). The adhesive resin layer (20) is disposed on the thermally conductive composite layer (10) and has a thermal conductivity of 0.27 W/m*K.

By means of adding the inorganic powders in the thermally conductive encapsulates of Examples 1 to 3, the thermally conductive encapsulates comprising the thermally conductive composite layers (10) and adhesive resin layers (20) have overall thermal impedances less than 0.72 °C-in²/W, respectively.

Table 2: the thermally conductive resin masterbatches used in Examples 1 to 3 and Comparative example 1 and their thermal impedances

**Table 2**

| | thermally conductive resin masterbatch | the overall thermal impedance of the thermally conductive encapsulate |
|---|---|---|
| Comparative example 1 | Preparation example 1 | 1.06 °C*in²/W |
| Example 1 | Preparation example 2 | 0.64 °C*in²/W |
| Example 2 | Preparation example 3 | 0.47 °C*in²/W |
| Example 3 | Preparation example 4 | 0.32 °C^{*}in²/W |

### Testing example 1: thermal conductance of the thermally conductive encapsulate

In the instant testing example, a back-sheet, a thermally conductive encapsulate of Examples 2 or 4 or a conventional sealing layer of Comparative example 1, a sealing resin layer and a transparent glass substrate were stacked in sequence to obtain a laminated sample for determining the thermal conductance of the thermally conductive encapsulate.

To ensure the significance of the experimental results, all laminated samples had identical back-sheet, identical sealing resin layer and identical transparent glass substrate in thickness and in material, and were tested by the same method and under the same environment. Thus, the thermal conductance of the laminated samples was directed to the thermal conductance of the conventional sealing layer and the thermally conductive encapsulate of Examples 1 and 3. Detailed experimental method was as follows.

An identical heat source was mounted on the transparent glass substrates of the laminated samples at a distance of 20 centimeters from each transparent glass substrate to heat the transparent glass substrates in a heating area about 10 square centimeters respectively. The thermal conduction time of each laminated sample was determined by the fact that the conventional sealing layer or the thermally conductive encapsulate started to transfer the thermal energy from the transparent glass substrate to the back-sheet until the temperature of back-sheet was increased to 30°C. The temperature of back-sheet was measured by infrared detector.

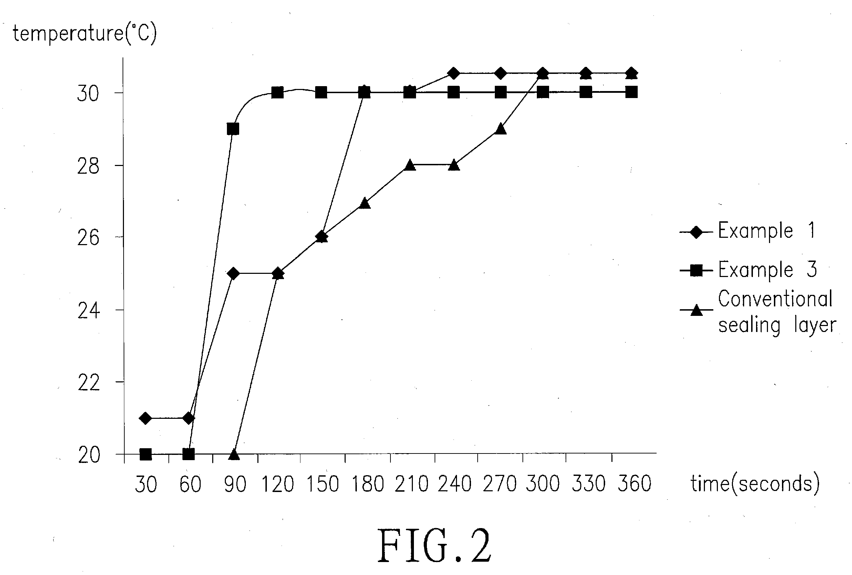

With reference to Fig. 2, the heat conduction time of the conventional sealing layer required almost 300 seconds; however, the thermal conduction time of the thermally conductive encapsulate only required 250 seconds, and even 90 to 100 seconds. It reveals that the thermally conductive encapsulates of Examples 1 and 3 do provide an excellent thermal conductance.

### Examples 4 to 6: solar cell modules comprising the thermally conductive encapsulates

The solar cell modules of Examples 4 to 6 respectively comprised the thermally conductive encapsulates of Examples 1 to 3, and all solar cell modules were prepared by a similar method as follows.

First, a transparent glass substrate, an EVA resin layer, an array of 72 monocrystalline silicon cells (purchased by Motech Industries, Inc.), 220 µm-thick thermally conductive encapsulate and polyester series back-sheet were stacked in sequence, the EVA resin layer was pressed at 140°C for thermal setting until a cross-linking density of 85%, so as to obtain a laminated structure.

Then a thermally conductive silicone resin sealant containing aluminum oxides were injected into the gaps of metal frame to obtain an aluminum frame loaded with the thermally conductive silicon resin sealant.

After that, the laminated structure was enclosed by the aluminum frame loaded with thermally conductive silicone resin sealant and then aged to complete the encapsulation process of the solar cell module.

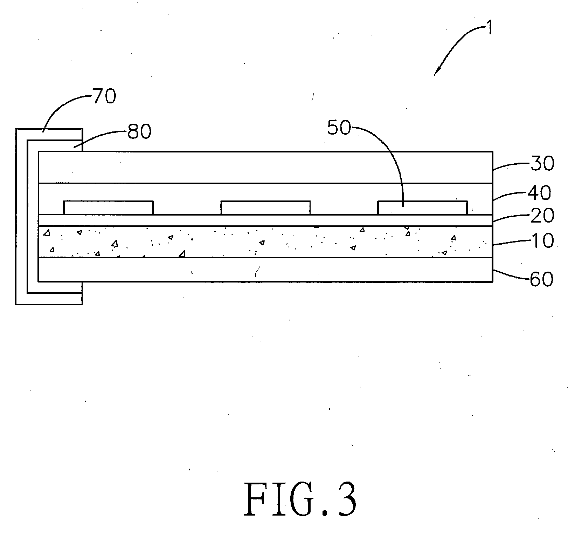

According to the method as mentioned above, the solar cell modules of Examples 4 to 6 have a similar structure as shown in Fig. 3, the difference between the Examples are the materials of the thermally conductive composite layers.

With reference to Fig. 3, the solar cell module (1) comprises a thermally conductive composite layer (10) as shown in Fig. 1, an adhesive resin layer (20), a transparent substrate (30), a sealing resin layer (40), multiple photoelectric conversion elements (50), a back-sheet (60), a metal frame (70) and a thermally conductive sealant (80).

The transparent substrate (30) is a 3mm-thick transparent glass substrate having a light transmittance more than 92%.

The sealing resin layer (40) is an EVA resin layer, which is disposed on the transparent substrate (30) and has a thickness about 450 micrometers and a thermal conductivity of 0.32 W/m*K.

The photoelectric conversion elements (50) are 72 monocrystalline silicon cells each having a thickness of 180 micrometers and two opposite surfaces. The photoelectric conversion elements (50) are arranged on the sealing resin layer (40) to form an array.

The adhesive resin layer (20) is a 20 µm-thick EGMA resin layer, a portion of the adhesive resin layer (20) is directly adhered to the surface of the photoelectric conversion elements (50), and the rest of the adhesive resin layer (20) is directly adhered to the bottom surface of the sealing resin layer (40) not in contact with the photoelectric conversion elements (50). One surface of each photoelectric conversion element (50) is adhered with the sealing resin layer (40) and the other surface of the photoelectric conversion element (50) is adhered with the adhesive resin layer (20). Accordingly, each and every photoelectric conversion element (50) is sealed by the adhesive resin layer (20) and the sealing resin layer (40), such that the photoelectric conversion elements (50) are fully isolated from the moisture in the external environments.

The thermally conductive composite layer (10) is a composite layer, which is manufactured by EMA resin compound with aluminum oxide powder and has a thickness of 200 micrometers. Said thermally conductive composite layer (10) is attached onto the surface of the adhesive resin layer (20) opposite to the photoelectric conversion elements (50).

The back-sheet (60) is a 350 µm-thick polyester series back-sheet and has a thermal conductivity of 0.28 W/m*K. The thermally conductive composite layer (10) is disposed between the adhesive resin layer (20) and the back-sheet (60).

The metal frame (70) is a heat-dissipation aluminum frame having a groove structure. A thermally conductive sealant (80) is injected into the groove structure of the metal frame (70), and the metal frame (70) is bonded to exteriors of the transparent substrate (30), the sealing resin layer (40), the adhesive rein layer (20), the thermally conductive composite layer (10) and the back-sheet by the thermally conductive sealant (80). Herein, the thermally conductive sealant (80) is made of a silicone resin compound with aluminum oxide and has a thermal conductivity of 1.0 W/m*K.

### Example 7: solar cell module comprising the thermally conductive encapsulate

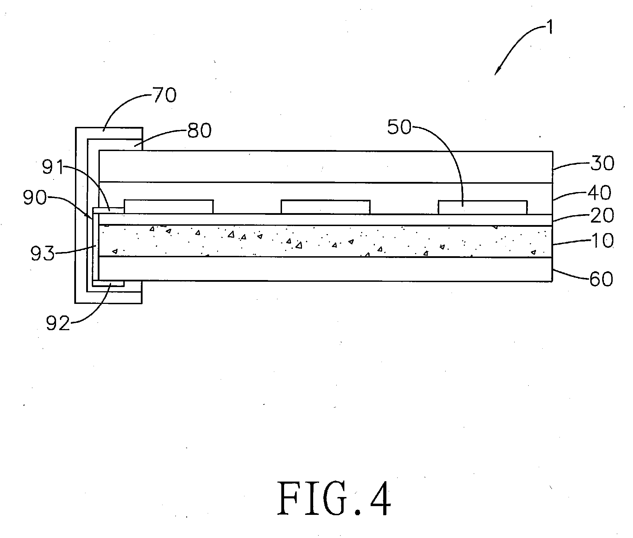

With reference to Fig. 4, the solar cell module (1) has a similar structure with those of Examples 4 to 6 and comprises a thermally conductive composite layer (10), an adhesive resin layer (20), a transparent substrate (30), a sealing resin layer (40), multiple photoelectric conversion elements (50), a back-sheet (60), a metal frame (70) and a thermally conductive sealant (80). The difference between the instant example and the Examples 4 to 6 is that the solar cell module (1) further comprises another thermally conductive composite layer (90), which is made of a material identical to that of the thermally conductive composite layer (10).

Said another thermally conductive composite layer (90) is interposed between the thermally conductive composite layer (10) and the thermally conductive sealant (80), between the adhesive resin layer (20) and the thermally conductive sealant (80), between the thermally conductive sealant (80) and the back-sheet (60), and is in contact with the photoelectric conversion element (50).

More specifically, said another thermally conductive composite layer (90) has two thermally conductive extension parts (91), (92) and a thermally conductive main part (93) formed between the thermally conductive extension parts (91), (92). The thermally conductive extension part (91) directly contacts the photoelectric conversion element (50) and is interposed between the sealing resin layer (40) and the adhesive resin layer (20). The thermally conductive main part (93) is mounted on the side surfaces of the thermally conductive encapsulate and of the back-sheet (60), and is interposed between the thermally conductive composite layer (10) and thermally conductive sealant (80), between the adhesive resin layer (20) and the thermally conductive sealant (80), and between the thermally conductive sealant (80) and the back-sheet (60). The thermally conductive main part (93) is interposed between the bottom surface of the back-sheet (60) and the thermally conductive sealant (80).

### Comparative example 2: conventional solar cell module

In the comparative example, a single EVA resin layer is used to replace the thermally conductive composite layer and the adhesive resin layer in the solar cell module of Example 4. Said EVA resin layer is interposed between the photoelectric conversion elements and the back-sheet, and the photoelectric conversion elements are sealed and enclosed by the EVA resin layer and the sealing resin layer. Furthermore, a silicone sealant with a thermal conductivity only 0.36 W/m*K is also used to replace the thermally conductive sealant of Example 4.

### Testing example 2: the operating temperature of the solar cell module

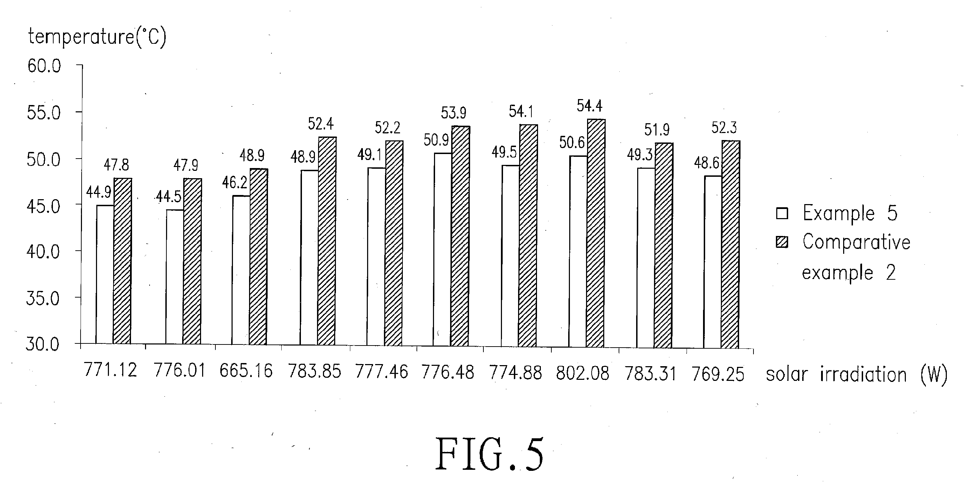

To verify that the thermally conductive encapsulate is useful for reducing the operating temperature of the solar cell module, the solar cell modules of Example 5 and Comparative example 2 were tested exposed to the identical solar irradiation at an ambient temperature of 29°C to 31°C, and the standard power outputs of the solar cell modules were 230 W per 1.7 square meters. The operating temperatures of the solar cell modules of Example 5 and Comparative example 2 were monitored with an infrared thermometer at various solar irradiations during the time between PM 12:00 and PM 1:00. The experimental results were shown in Fig. 5, every operating temperature as shown in Fig. 5 was obtained from the average of nine experimental results.

Fig. 5 supports that the conventional EVA resin layer with a thermal conductivity of 0.32 W/m*K cannot effectively transfer the thermal energy, which is not converted into the electrical energy, to the adjacent silicone sealant or adjacent back-sheet, thereby failing to dissipate the heat generated from the photoelectric conversion element to the environment. On the contrary, the thermally conductive encapsulate, comprising a thermally conductive composite layer with a thermal conductivity of 0.87 W/m*K and having an overall thermal impedance of 0.36°C-in²/W, can effectively transfer the thermal energy to the adjacent back-sheet or transfer the thermal energy to the environment through the thermally conductive sealant and the metal frame. Accordingly, the thermally conductive encapsulate does provide a good heat-transfer path to decrease the operating temperature of the solar cell module.

### Testing example 3: the power output of the solar cell module

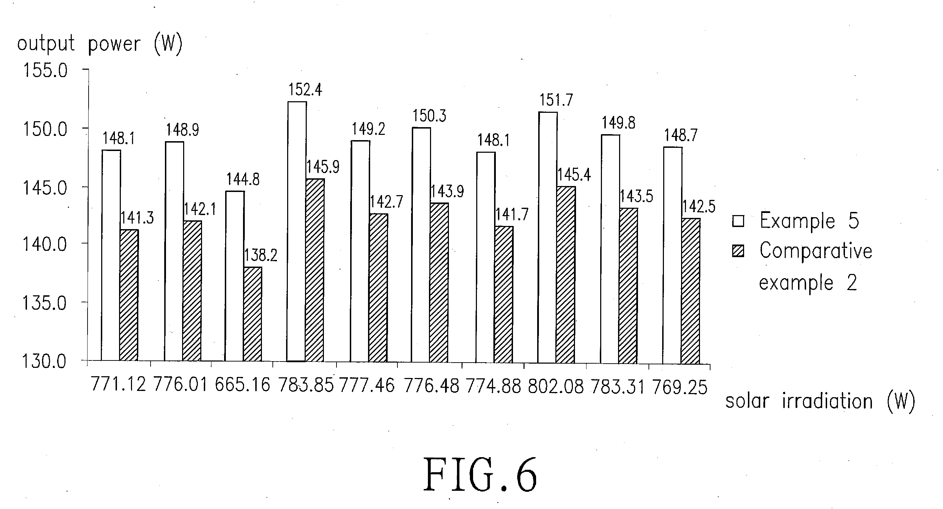

To verify that the thermally conductive encapsulate is useful for improving the solar cell module's power outputs, the solar cell modules of Example 5 and Comparative example 2 were tested under the identical solar irradiation at an ambient temperature of 29°C to 31°C, and the standard power outputs of the solar cell modules were 230 W per 1.7 square meters. The power outputs of the solar cell modules of Example 5 and Comparative example 2 were monitored with a real-time solar monitoring system at various solar irradiations during the time between PM 12:00 and PM 1:00. The experimental results were shown in Fig. 6.

With reference to Fig. 6, it demonstrates that most solar cell modules' power outputs in Example 5 are 6.4 W higher than those in Comparative example 2 during the time between PM 12:00 and PM 1:00. Moreover, the total power outputs of the solar cell modules in Example 5 is also 4W higher than that in Comparative example 2.

### Testing example 4: the power outputs of the solar cell modules

In the testing example, the solar cell modules of Examples 4 to 6 and the conventional solar cell module of Comparative example 2 were tested under 1000 W of solar irradiation at an ambient temperature of 31°C to 33°C during the time between AM 10:00 and PM 3:00. The power outputs of the solar cell modules of Examples 4 to 6 and Comparative example 2 were monitored with a real-time solar monitoring system. The experimental results were listed in Fig. 6.

**Table 3: the theoretical irradiations, maximum power outputs and total power outputs of the solar cell modules in Examples 4 and 6 and of the conventional solar cell module in Comparative example 2, and the power output difference between the samples and Comparative example 2**

| Sample No. | theoretical irradiation under 1000 W | maximum power output | total power output during the time between AM10:00 and PM 3:00 | power output difference |
|---|---|---|---|---|
| Comparative example 2 | 235.489W | 163.9 W | 37418.9 W | 0 |
| Example 4 | 235.871W | 164.6 W | 37470.2 W | 51.3W |
| Example 6 | 235.711W | 169.3 W | 37984.1 W | 565.2W |

As shown in Table 3, the thermally conductive encapsulate and the thermally conductive sealant can transfer the heat generated by the photoelectric conversion elements to the environment through a lateral pathway from the thermally conductive composite layer, the thermally conductive sealant and the metal frame, thereby improving the heat-dissipating rate and efficiency. Accordingly, all solar cell modules of Examples 4 to 6 have much higher maximum power outputs and much higher total power outputs than those of the Comparative example 2.

In conclusion, the thermally conductive encapsulates of the solar cell modules in Examples 4 to 6 not only dissipate the thermal energy effectively to maintain a lower operating temperature, but also improve the solar cell module's conversion efficiency to allow higher power outputs. Thus, the solar cell module comprising the thermally conductive encapsulate is more applicable in the related field.

Even though numerous characteristics and advantages of the present invention have been set forth in the foregoing description, together with details of the structure and features of the invention, the disclosure is illustrative only. Changes may be made in the details, especially in matters of shape, size, and arrangement of parts within the principles of the invention to the full extent indicated by the broad general meaning of the terms in which the appended claims are expressed.

## Claims

1. A thermally conductive encapsulate, comprising a thermally conductive composite layer (10) and an adhesive resin layer (20) disposed on the thermally conductive composite layer (10), and the thermally conductive encapsulate **characterized in that**:
the thermally conductive composite layer (10) includes a thermoplastic resin (101) and inorganic powders (102) dispersed in the thermoplastic resin (101) in an amount of 40 vol% to 70 vol% based on a volume of the thermally conductive composite layer (10), the thermally conductive composite layer (10) having a thermal conductivity ranging from 0.5 W/m*K to 8 W/m*K; and
the adhesive resin layer (20) has a thermal conductivity ranging from 0.05 W/m*K to 0.4 W/m*K; and
a percentage of a thickness of the adhesive resin layer (20) relative to a total thickness of the thermally conductive encapsulate ranges from 0.1% to 10%, and the thermally conductive encapsulate has an overall thermal impedance ranging from 0.01 °C*in²/W to 0.72 °C*in²/W,
wherein the thermal conductivities are measured according to ASTM E1461.

2. The thermally conductive encapsulate as claimed in claim 1, wherein the thermoplastic resin (101) of the thermally conductive composite layer (10) has a thermal conductivity ranging from 0.05 W/m*K to 0.4 W/m*K.

3. The thermally conductive encapsulate as claimed in claim 1, wherein the inorganic powders (102) have a median particle size equal to or less than 20 micrometers and a material of the inorganic powders (102) includes inorganic oxide, inorganic nitride or any combination thereof.

4. The thermally conductive encapsulate as claimed in claim 3, wherein the median particle size of the inorganic powders (102) ranges from 1 micrometer to 3 micrometers, and the material of the inorganic powders (102) includes aluminum oxide, aluminum nitride, boron nitride or any combination thereof.

5. The thermally conductive encapsulate as claimed in claim 1, wherein the inorganic powders (102) have a median particle size equal to or less than 20 micrometers, and a material of the inorganic powders (102) includes silicon carbide.

6. The thermally conductive encapsulate as claimed in claim 1, wherein the total thickness of the thermally conductive encapsulate ranges from 20 micrometers to 600 micrometers.

7. A solar cell module (1), comprising a transparent substrate (30), a sealing resin layer (40) disposed on the transparent substrate (30), a photoelectric conversion element (50) disposed on the sealing resin layer (40), a thermally conductive encapsulate disposed on the photoelectric conversion element (50) and the sealing resin layer (40), the thermally conductive encapsulate comprising a thermally conductive composite layer (10) and an adhesive resin layer (20) disposed between the photoelectric conversion element (50) and the thermally conductive composite layer (10), the adhesive resin layer (20) being in contact with the photoelectric conversion element (50), and a back-sheet (60) disposed on the thermally conductive composite layer (10) of the thermally conductive encapsulate, and the thermally conductive encapsulate **characterized in that**:
the thermally conductive composite layer (10) includes a thermoplastic resin (101) and inorganic powders (102) dispersed in the thermoplastic resin (101) in an amount of 40 vol% to 70 vol% based on the volume of the thermally conductive composite layer (10), the thermally conductive composite layer (10) having a thermal conductivity ranging from 0.5 W/m*K to 8 W/m*K;
the adhesive resin layer (20) has a thermal conductivity ranging from 0.05 W/m*K to 0.4 W/m*K; and
a percentage of a thickness of the adhesive resin layer (20) relative to a total thickness of the thermally conductive encapsulate ranges from 0.1% to 10%, and the thermally conductive encapsulate has an overall thermal impedance ranging from 0.01 °C*in²/W to 0.72 °C*in²/W,
wherein the thermal conductivities are measured according to ASTM E1461.

8. The solar cell module (1) as claimed in claim 7, wherein the thermoplastic resin (101) of the thermally conductive composite layer (10) has a thermal conductivity ranging from 0.05 W/m*K to 0.4 W/m*K, and the total thickness of the thermally conductive encapsulate ranges from 20 micrometers to 600 micrometers.

9. The solar cell module (1) as claimed in claim 7, wherein the inorganic powders (102) have a median particle size equal to or less than 20 micrometers and a material of the inorganic powders (102) includes inorganic oxide, inorganic nitride or any combination thereof.

10. The solar cell module (1) as claimed in claim 9, wherein the median particle size of the inorganic powders (102) ranges from 1 micrometer to 3 micrometers, and the material of the inorganic powders (102) includes aluminum oxide, aluminum nitride, boron nitride or any combination thereof.

11. The solar cell module (1) as claimed in claim 7, wherein the inorganic powders (102) have a median particle size equal to or less than 20 micrometers, and a material of the inorganic powders (102) includes silicon carbide.

12. The solar cell module (1) as claimed in claim 7, wherein the solar cell module (1) comprises another thermally conductive composite layer (90) disposed at exteriors of the thermally conductive encapsulate and the back-sheet (60) and in contact with the photoelectric conversion element (50).

13. The solar cell module (1) as claimed in claim 7, wherein the solar cell module (1) comprises a thermally conductive sealant (80) having a thermal conductivity ranging from 0.05 W/m*K to 0.4 W/m*K and a metal frame (70), the metal frame (70) is bonded to exteriors of the transparent substrate (30), the sealing resin layer (40), the thermally conductive encapsulate and the back-sheet (60) by the thermally conductive sealant (80).

14. The solar cell module (1) as claimed in claim 13, wherein the solar cell module (1) comprises another thermally conductive composite layer (90) disposed between the thermally conductive sealant (80) and the thermally conductive encapsulate and between the thermally conductive sealant (80) and the back-sheet (60), and said another thermally conductive composite layer (90) contacts the photoelectric conversion element (50).

15. The solar cell module (1) as claimed in claim 12 or 14, wherein said another thermally conductive composite layer (90) comprises a thermoplastic resin and inorganic powders dispersed in the thermoplastic resin of said another thermally conductive composite layer (90) in an amount of 10 vol% to 70 vol% based on the volume of said another thermally conductive composite layer (90), and said another thermally conductive composite layer (90) has a thermal conductivity ranging from 0.5 W/m*K to 8 W/m*K.

## Patentansprüche

1. Wärmeleitende Einkapselung, die eine wärmeleitende Verbundstoffschicht (10) und eine Klebharzschicht (20) aufweist, die auf der wärmeleitenden Verbundstoffschicht (10) angeordnet ist, und wobei die wärmeleitende Einkapselung **dadurch gekennzeichnet ist, dass**:
die wärmeleitende Verbundstoffschicht (10) ein thermoplastisches Harz (101) und anorganische Pulver (102) enthält, die in dem thermoplastischen Harz (101) in einem Anteil von 40 Vol.-% bis 70 Vol.-% auf der Grundlage eines Volumens der wärmeleitenden Verbundstoffschicht (10) verteilt sind, wobei die wärmeleitende Verbundstoffschicht (10) eine Wärmeleitfähigkeit im Bereich von 0,5 W/m*K bis 8 W/m*K aufweist; und
die Klebharzschicht (20) eine Wärmeleitfähigkeit im Bereich von 0,05 W/m*K bis 0,4 W/m*K aufweist; und
ein Prozentsatz einer Dicke der Klebharzschicht (20) in Bezug auf eine Gesamtdicke der wärmeleitenden Einkapselung im Bereich von 0,1% bis 10% liegt, und die wärmeleitende Einkapselung eine gesamte thermische Impedanz im Bereich von 0,01 °C*Quadratzoll/W bis 0,72 °C*Quadratzoll/W aufweist,
wobei die Wärmeleitfähigkeiten gemäß ASTM E1461 gemessen werden.

2. Wärmeleitende Einkapselung nach Anspruch 1, wobei das thermoplastische Harz (101) der wärmeleitenden Verbundstoffschicht (10) eine Wärmeleitfähigkeit im Bereich von 0,05 W/m*K bis 0,4 W/m*K aufweist.

3. Wärmeleitende Einkapselung nach Anspruch 1, wobei die anorganischen Pulver (102) eine durchschnittliche Partikelgröße von kleiner gleich 20 µm aufweisen, und ein Material der anorganischen Pulver (102) anorganisches Oxid, anorganisches Nitrid oder eine beliebige Kombination davon enthält.

4. Wärmeleitende Einkapselung nach Anspruch 3, wobei die durchschnittliche Partikelgröße der anorganischen Pulver (102) im Bereich von 1 Mikrometer bis 3 µm liegt, und das Material der anorganischen Pulver (102) Aluminiumoxid, Aluminiumnitrid, Bornitrid oder eine beliebige Kombination davon enthält.

5. Wärmeleitende Einkapselung nach Anspruch 1, wobei die anorganischen Pulver (102) eine durchschnittliche Partikelgröße von kleiner gleich 20 µm aufweisen, und ein Material der anorganischen Pulver (102) Siliziumkarbid enthält.

6. Wärmeleitende Einkapselung nach Anspruch 1, wobei die Gesamtdicke der wärmeleitenden Einkapselung im Bereich von 20 µm bis 600 µm liegt.

7. Solarzellenmodul (1), das ein transparentes Substrat (30), eine dichtende Harzschicht (40), die auf dem transparenten Substrat (30) angeordnet ist, ein fotoelektrisches Umwandlungselement (50), das auf der dichtenden Harzschicht (40) angeordnet ist, eine wärmeleitende Einkapselung, die auf dem photoelektrischen Umwandlungselement (50) angeordnet ist, und die dichtende Harzschicht (40) aufweist, wobei die wärmeleitende Einkapselung eine wärmeleitende Verbundstoffschicht (10) und eine Klebharzschicht (20) aufweist, die zwischen dem photoelektrischen Umwandlungselement (50) und dem wärmeleitenden Verbundstoffschicht (10) angeordnet ist, wobei die Klebharzschicht (20) mit dem photoelektrischen Umwandlungselement (50) in Berührung steht, und eine Rückseitenfolie (60) auf der wärmeleitenden Verbundstoffschicht (10) der wärmeleitenden Einkapselung angeordnet ist, und wobei die wärmeleitende Einkapselung **dadurch gekennzeichnet ist, dass**:
die wärmeleitende Verbundstoffschicht (10) ein thermoplastisches Harz (101) und anorganische Pulver (102) enthält, die in dem thermoplastischen Harz (101) in einem Anteil von 40 Vol.-% bis 70 Vol.-% auf der Grundlage des Volumens der wärmeleitenden Verbundstoffschicht (10) verteilt sind, wobei die wärmeleitende Verbundstoffschicht (10) eine Wärmeleitfähigkeit im Bereich von 0,5 W/m*K bis 8 W/m*K aufweist;
die Klebharzschicht (20) eine Wärmeleitfähigkeit im Bereich von 0,05 W/m*K bis 0,4 W/m*K aufweist; und
ein Prozentsatz einer Dicke der Klebharzschicht (20) in Bezug auf eine Gesamtdicke der wärmeleitenden Einkapselung im Bereich von 0,1% bis 10% liegt, und die wärmeleitende Einkapselung eine gesamte thermische Impedanz im Bereich von 0,01 °C*Quadratzoll/W bis 0,72 °C*Quadratzoll/W aufweist,
wobei die Wärmeleitfähigkeiten gemäß AS TM E1461 gemessen werden.

8. Solarzellenmodul (1) nach Anspruch 7, wobei das thermoplastische Harz (101) der wärmeleitenden Verbundstoffschicht (10) eine Wärmeleitfähigkeit im Bereich von 0,05 W/m*K bis 0,4 W/m*K aufweist, und die Gesamtdicke der wärmeleitenden Einkapselung im Bereich von 20 µm bis 600 µm liegt.

9. Solarzellenmodul (1) nach Anspruch 7, wobei die anorganischen Pulver (102) eine durchschnittliche Partikelgröße von kleiner gleich 20 µm aufweisen, und ein Material der anorganischen Pulver (102) anorganisches Oxid, anorganisches Nitrid oder eine beliebige Kombination davon enthält.

10. Solarzellenmodul (1) nach Anspruch 9, wobei die durchschnittliche Partikelgröße der anorganischen Pulver (102) im Bereich von 1 Mikrometer bis 3 µm liegt, und das Material der anorganischen Pulver (102) Aluminiumoxid, Aluminiumnitrid, Bornitrid oder eine beliebige Kombination davon enthält.

11. Solarzellenmodul (1) nach Anspruch 7, wobei die anorganischen Pulver (102) eine durchschnittliche Partikelgröße von kleiner gleich 20 µm aufweisen, und ein Material der anorganischen Pulver (102) Siliziumkarbid enthält.

12. Solarzellenmodul (1) nach Anspruch 7, wobei das Solarzellenmodul (1) eine weitere wärmeleitende Verbundstoffschicht (90) aufweist, die an Außenseiten der wärmeleitenden Einkapselung und der Rückseitenfolie (60) angeordnet ist und mit dem photoelektrischen Umwandlungselement (50) in Berührung steht.

13. Solarzellenmodul (1) nach Anspruch 7, wobei das Solarzellenmodul (1) ein wärmeleitendes Dichtungsmittel (80) mit einer Wärmeleitfähigkeit im Bereich von 0,05 W/m*K bis 0,4 W/m*K und einem Metallrahmen (70) aufweist, wobei der Metallrahmen (70) mittels des wärmeleitenden Dichtungsmittels (80) mit Außenseiten des transparenten Substrats (30), der dichtenden Harzschicht (40), der wärmeleitenden Einkapselung und der Rückseitenfolie (60) haftend verbunden ist.

14. Solarzellenmodul (1) nach Anspruch 13, wobei das Solarzellenmodul (1) eine weitere wärmeleitende Verbundstoffschicht (90) aufweist, die zwischen dem wärmeleitenden Dichtungsmittel (80) und der wärmeleitenden Einkapselung und zwischen dem wärmeleitenden Dichtungsmittel (80) und der Rückseitenfolie (60) angeordnet ist, und wobei die weitere wärmeleitende Verbundstoffschicht (90) mit dem photoelektrischen Umwandlungselement (50) in Berührung steht.

15. Solarzellenmodul (1) nach Anspruch 12 oder 14, wobei die weitere wärmeleitende Verbundstoffschicht (90) ein thermoplastisches Harz und anorganische Pulver enthält, die in dem thermoplastischen Harz der weiteren wärmeleitenden Verbundstoffschicht (90) in einem Anteil von 10 Vol.-% bis 70 Vol.-% auf der Grundlage des Volumens der weiteren wärmeleitenden Verbundstoffschicht (90) verteilt sind, und wobei die weitere wärmeleitende Verbundstoffschicht (90) eine Wärmeleitfähigkeit im Bereich von 0,5 W/m*K bis 8 W/m*K aufweist.

## Revendications

1. Composant encapsulant thermo-conducteur, comprenant une couche composite thermo-conductrice (10) et une couche (20) de résine adhésive, disposée sur la couche composite thermo-conductrice (10), lequel composant encapsulant thermo-conducteur est **caractérisé en ce que** :
- la couche composite thermo-conductrice (10) comprend une résine thermoplastique (101) et une poudre inorganique (102) dispersée dans la résine thermoplastique (101), en une proportion de 40 % à 70 %, en volume rapporté au volume de la couche composite thermo-conductrice (10), et cette couche composite thermo-conductrice (10) présente une conductivité thermique qui vaut de 0,5 à 8 W/m.K ;
- la couche (20) de résine adhésive présente une conductivité thermique qui vaut de 0,05 à 0,4 W/m.K ;
- l'épaisseur de la couche (20) de résine adhésive représente de 0,1 à 10 % de l'épaisseur totale du composant encapsulant thermo-conducteur ;
- et le composant encapsulant thermo-conducteur présente une impédance thermique globale qui vaut de 0,01 à 0,72 °C.(pouce)²/W ;
étant entendu que les conductivités thermiques sont mesurées suivant la norme ASTM E1461.

2. Composant encapsulant thermo-conducteur conforme à la revendication 1, dans lequel la résine thermoplastique (101) de la couche composite thermo-conductrice (10) présente une conductivité thermique qui vaut de 0,05 à 0,4 W/m.K.

3. Composant encapsulant thermo-conducteur conforme à la revendication 1, dans lequel la poudre inorganique (102) présente une taille médiane de particules inférieure ou égale à 20 µm et le matériau de cette poudre inorganique (102) comprend un oxyde inorganique, un nitrure inorganique, ou une combinaison de tels matériaux.

4. Composant encapsulant thermo-conducteur conforme à la revendication 3, dans lequel la taille médiane des particules de la poudre inorganique (102) vaut de 1 à 3 µm et le matériau de cette poudre inorganique (102) comprend de l'oxyde d'aluminium, du nitrure d'aluminium ou du nitrure de bore, ou une combinaison de ces matériaux.

5. Composant encapsulant thermo-conducteur conforme à la revendication 1, dans lequel la poudre inorganique (102) présente une taille médiane de particules inférieure ou égale à 20 µm et le matériau de cette poudre inorganique (102) comprend du carbure de silicium.

6. Composant encapsulant thermo-conducteur conforme à la revendication 1, duquel composant encapsulant thermo-conducteur l'épaisseur totale vaut de 20 à 600 µm.

7. Module (1) à cellules solaires, comprenant un substrat transparent (30), une couche (40) de résine de scellement disposée par-dessus ce substrat transparent (30), un élément (50) de conversion photo-électrique placé sur la couche (40) de résine de scellement, un composant encapsulant thermo-conducteur disposé par-dessus l'élément (50) de conversion photo-électrique et la couche (40) de résine de scellement, lequel composant encapsulant thermo-conducteur comprend une couche composite thermo-conductrice (10) et une couche (20) de résine adhésive, disposée entre l'élément (50) de conversion photo-électrique et la couche composite thermo-conductrice (10), la couche (20) de résine adhésive se trouvant au contact de l'élément (50) de conversion photo-électrique, et une feuille de dos (60) disposée par-dessus la couche composite thermo-conductrice (10) du composant encapsulant thermo-conducteur, lequel composant encapsulant thermo-conducteur est **caractérisé en ce que** :
- la couche composite thermo-conductrice (10) comprend une résine thermoplastique (101) et une poudre inorganique (102) dispersée dans la résine thermoplastique (101), en une proportion de 40 % à 70 %, en volume rapporté au volume de la couche composite thermo-conductrice (10), et cette couche composite thermo-conductrice (10) présente une conductivité thermique qui vaut de 0,5 à 8 W/m.K ;
- la couche (20) de résine adhésive présente une conductivité thermique qui vaut de 0,05 à 0,4 W/m.K ;
- l'épaisseur de la couche (20) de résine adhésive représente de 0,1 à 10 % de l'épaisseur totale du composant encapsulant thermo-conducteur ;
- et le composant encapsulant thermo-conducteur présente une impédance thermique globale qui vaut de 0,01 à 0,72 °C.(pouce)²/W ;
étant entendu que les conductivités thermiques sont mesurées suivant la norme ASTM E1461.

8. Module (1) à cellules solaires, conforme à la revendication 7, dans lequel la résine thermoplastique (101) de la couche composite thermo-conductrice (10) présente une conductivité thermique qui vaut de 0,05 à 0,4 W/m.K, et l'épaisseur totale du composant encapsulant thermo-conducteur vaut de 20 à 600 µm.

9. Module (1) à cellules solaires, conforme à la revendication 7, dans lequel la poudre inorganique (102) présente une taille médiane de particules inférieure ou égale à 20 µm et le matériau de cette poudre inorganique (102) comprend un oxyde inorganique, un nitrure inorganique, ou une combinaison de tels matériaux.

10. Module (1) à cellules solaires, conforme à la revendication 9, dans lequel la taille médiane des particules de la poudre inorganique (102) vaut de 1 à 3 µm et le matériau de cette poudre inorganique (102) comprend de l'oxyde d'aluminium, du nitrure d'aluminium ou du nitrure de bore, ou une combinaison de ces matériaux.

11. Module (1) à cellules solaires, conforme à la revendication 7, dans lequel la poudre inorganique (102) présente une taille médiane de particules inférieure ou égale à 20 µm et le matériau de cette poudre inorganique (102) comprend du carbure de silicium.

12. Module (1) à cellules solaires, conforme à la revendication 7, lequel module (1) à cellules solaires comprend une autre couche composite thermo-conductrice (90), qui est disposée sur les faces externes du composant encapsulant thermo-conducteur et de la feuille de dos (60) et qui est en contact avec l'élément (50) de conversion photo-électrique.

13. Module (1) à cellules solaires, conforme à la revendication 7, lequel module (1) à cellules solaires comprend un élément d'étanchéité thermo-conducteur (80), qui présente une conductivité thermique valant de 0,05 à 0,4 W/m.K, et un cadre métallique (70), lequel cadre métallique (70) est fixé, au moyen de l'élément d'étanchéité thermo-conducteur (80), sur les faces externes du substrat transparent (30), de la couche (40) de résine de scellement, du composant encapsulant thermo-conducteur et de la feuille de dos (60).

14. Module (1) à cellules solaires, conforme à la revendication 13, lequel module (1) à cellules solaires comprend une autre couche composite thermo-conductrice (90), qui est disposée entre l'élément d'étanchéité thermo-conducteur (80) et le composant encapsulant thermo-conducteur et entre l'élément d'étanchéité thermo-conducteur (80) et la feuille de dos (60), laquelle autre couche composite thermo-conductrice (90) est en contact avec l'élément (50) de conversion photo-électrique.

15. Module (1) à cellules solaires, conforme à la revendication 12 ou 14, dans lequel ladite autre couche composite thermo-conductrice (90) comprend une résine thermoplastique et une poudre inorganique, dispersée dans la résine thermoplastique de cette autre couche composite thermo-conductrice (90) en une proportion de 10 % à 70 %, en volume rapporté au volume de ladite autre couche composite thermo-conductrice (90), et cette autre couche composite thermo-conductrice (90) présente une conductivité thermique qui vaut de 0,5 à 8 W/m.K.
